# EUROPEAN PATENT APPLICATION

(11) **EP 1 854 627 A1**
(43) Date of publication of application: **14.11.2007**
(21) Application number: 06113868.1
(22) Date of filing: 12.05.2006
(51) Int. Cl.: B41C 1/10, G03F 7/32

(54) **Method for making a lithographic printing plate**

(71) Applicant: Agfa Graphics N.V., 2640 Mortsel (BE)
(72) Inventor: Lingier, Stefaan AGFA-Graphics NV, 2640, Mortsel (BE)
(74) Representative: Goedeweeck, Rudi

(57) **Abstract**

A method for making a lithographic printing plate is disclosed which comprises the steps of:
(1) providing a heat-sensitive lithographic printing plate precursor comprising on a support having a hydrophilic surface or which is provided with a hydrophilic layer, a heat-sensitive coating, said coating comprising a first layer comprising a first polymer which is water-insoluble and alkali-soluble, and on said first layer, a second layer comprising a second polymer which is water-insoluble and alkali-soluble, and an infrared absorbing dye, present in at least one of said first and second layer,
(2) image-wise exposing said precursor with IR-radiation or heat whereby said second layer exhibits an increased solubility in an aqueous alkaline developing solution, and
(3) developing said image-wise exposed precursor with an aqueous alkaline developing solution, said solution comprising an alkali metal or ammonium salt of an aliphatic carboxylic acid, having 8 to 11 carbon atoms.

According to the above method, the formation of insoluble products in the developing solution is inhibited or reduced.

## Description

### FIELD OF THE INVENTION

The present invention relates to a method for making a lithographic printing plate wherein an image-wise exposed precursor is developed with an alkaline developing solution comprising an aliphatic carboxylic acid having 8 to 11 carbon atoms.

### BACKGROUND OF THE INVENTION

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Printing masters are generally obtained by the image-wise exposure and processing of an imaging material called plate precursor. A typical positive-working plate precursor comprises a hydrophilic support and an oleophilic coating which is not readily soluble in an aqueous alkaline developer in the non-exposed state and becomes soluble in the developer after exposure to radiation. In addition to the well known photosensitive imaging materials which are suitable for UV contact exposure through a film mask (the so-called pre-sensitized plates), also heat-sensitive printing plate precursors have become very popular. Such thermal materials offer the advantage of daylight stability and are especially used in the so-called computer-to-plate method (CtP) wherein the plate precursor is directly exposed, i.e. without the use of a film mask. The material is exposed to heat or to infrared light and the generated heat triggers a (physico-)chemical process, such as ablation, polymerization, insolubilization by cross-linking of a polymer or by particle coagulation of a thermoplastic polymer latex, and solubilization by the destruction of intermolecular interactions or by increasing the penetrability of a development barrier layer.

Although some of these thermal processes enable plate making without wet processing, the most popular thermal plates form an image by a heat-induced solubility difference in an alkaline developer between exposed and non-exposed areas of the coating. The coating typically comprises an oleophilic binder of which the rate of dissolution in the developer is either reduced (negative working) or increased (positive working) by the image-wise exposure.

Typically, the oleophilic resin in a heat-sensitive plate is a phenolic resin such as novolac, resol or a polyvinylphenolic resin. The phenolic resin can be chemically modified whereby the phenolic monomeric unit is substituted by a group such as described in WO99/01795, EP 934 822, EP 1 072 432, US 3,929,488, EP 2 102 443, EP 2 102 444, EP 2 102 445, EP 2 102 446. The phenolic resin can also been mixed with other polymers as described in WO 2004/020484, US 6,143,464, WO 2001/09682, EP 933 682, WO 99/63407, WO 2002/53626, EP 1 433 594 and EP 1 439 058. The coating can also be composed of two or more layers, each of them comprising one or more of the above described resins as described in e.g. EP 864 420, EP 909 657, EP-A 1 011 970, EP-A 1 263 590, EP-A 1 268 660, EP-A 1 072 432, EP-A 1 120 246, EP-A 1 303 399, EP-A 1 311 394, EP-A 1 211 065, EP-A 1 368 413, EP-A 1 241 003,EP-A 1 299 238, EP-A 1 262 318, EP-A 1 275 498, EP-A 1 291 172, WO 2003/74287, WO 2004/33206, EP-A 1 433 594, EP-A 1 439 058, WO 2002/33491, EP-A 1 376 241, EP-A 1 275 498, EP-A 1 398 151. In these materials an under layer and an upper layer are provided on a support. In the upper layer, a dissolution inhibitor is added to a phenolic resin as binder whereby the rate of dissolution of the coating is reduced. Upon heating, this reduced rate of dissolution of the coating is increased on the exposed areas compared with the non-exposed areas, resulting in a sufficient difference in solubility of the coating after image-wise recording by heat or IR-radiation. In the under layer, an alkali-soluble resin is added, e.g. to improve the chemical resistance of the plate resulting in a higher printing run length.

During processing, the solubility differential leads to the removal of non-image (non-printing) areas of the coating, thereby revealing the hydrophilic support, while image (printing) areas of the coating remain on the support. Thereby, the upper and the under layer of the coating of the non-image (non-printing) areas are solubilized in the alkaline developing solution and the ingredients constituting the coating of these two layers cumulate in the developing solution and all kind of interactions between these ingredients can result in the formation of a first type of insoluble products which flocculate and precipitate in the developing solution, also known as sludge. This sludge can be removed by filtration or decantation of the developing solution. Beside this sludge formation, other insoluble products can be formed which do not precipitate and which can not been filtered off but remain on the surface of the developing solution. This second type of insoluble products, floating on the surface of the developing solution, also referred to as floating products, may adhere on the surface of the rollers present in the developing machine and may further impair the image on the printing plates. As a result, the developing solution needs to be changed regularly to prevent this problem.

### SUMMARY OF THE INVENTION

It is an aspect of the present invention to provide a method for making a heat-sensitive lithographic printing plate whereby excellent printing properties are obtained and whereby the formation of floating products is inhibited or reduced. This object is realized by the method defined in claim 1, having the characteristic feature that the developing solution in the developing step comprises an aliphatic carboxylic acid having 8 to 11 carbon atoms.

Specific embodiments of the invention are defined in the dependent claims.

### DETAILED DESCRIPTION OF THE INVENTION

In accordance with the present invention, there is provided a method for making a lithographic printing plate comprising the steps of:
(1) providing a heat-sensitive lithographic printing plate precursor comprising on a support having a hydrophilic surface or which is provided with a hydrophilic layer, a heat-sensitive coating, said coating comprising a first layer comprising a first polymer which is water-insoluble and alkali-soluble, and on said first layer, a second layer comprising a second polymer which is water-insoluble and alkali-soluble, and an infrared absorbing dye, present in at least one of said first and second layer,
(2) image-wise exposing said precursor with IR-radiation or heat whereby said second layer exhibits an increased solubility in an aqueous alkaline developing solution, and
(3) developing said image-wise exposed precursor with an aqueous alkaline developing solution, said solution comprising an alkali metal or ammonium salt of an aliphatic carboxylic acid, having 8 to 11 carbon atoms.

In a preferred embodiment, said aliphatic carboxylic acid is octanoic acid, nonanoic acid, decanoic acid or undecanoic acid. In a more preferred embodiment, said aliphatic carboxylic acid is octanoic acid, nonanoic acid or decanoic acid, most preferably octanoic acid or nonanoic acid.

During developing of an image-wise exposed heat-sensitive lithographic printing plate precursor, said salt of said aliphatic carboxylic acid is present in the aqueous alkaline developing solution. In accordance with a preferred embodiment of the present invention, said salt of said aliphatic carboxylic acid is present in the alkaline developing solution at the start of the developing process. In accordance with another preferred embodiment of the present invention, said salt of said aliphatic carboxylic acid is added to the alkaline developing solution during the developing process by a replenishing solution comprising said salt of said aliphatic carboxylic acid.

### Developing solution

The aqueous alkaline developing solution (hereinafter also referred to as "developer") comprises an alkaline agent.

In an embodiment of the present invention, said alkaline agent comprises an inorganic alkaline agent such as sodium hydroxide, potassium hydroxide, lithium hydroxide, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium bicarbonate, potassium bicarbonate, ammonium bicarbonate, sodium borate, potassium borate and ammonium borate, and potassium citrate, sodium citrate and the like.

The alkaline agent may also include organic alkaline agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethylenediamine, pyridine and the like.

In a preferred embodiment of the present invention, said alkaline agent comprises an alkaline silicate or metasilicate. The alkaline silicate or metasilicate exhibits an alkalinity when dissolved in water, and examples thereof include an alkali metal silicate and alkali metal metasilicate such as sodium silicate, sodium metasilicate, potassium silicate and lithium silicate, and ammonium silicate. Said alkaline silicate may be used alone, or in combination with another alkaline agent.

The development performance of the alkaline aqueous solution may be easily modulated by adjusting a molar ratio of alkaline silicates and alkali metal hydroxides, represented by silicon oxide (SiO₂) and an alkali oxide (M₂O, wherein M represents an alkali metal or an ammonium group). The alkaline aqueous solution has preferably a molar ratio SiO₂/M₂O from 0.5 to 3.0, and more preferably from 1.0 to 2.0. When the molar ratio SiO₂/M₂O is less than 0.5, alkalinity of the solution strengthens so as to cause a harmful effect such as etching of an aluminum plate which is generally used as a substrate in a lithographic printing plate precursor. When the molar ratio, SiO_{2/}M₂O is more than 3.0, the development performance of the solution may be degraded.

The concentration of alkaline silicate in the developer ranges generally from 1 to 14% by weight, preferably from 3 to 14% by weight, and more preferably from 4 to 14% by weight. When said concentration is less than 1% by weight, the development performance or treatment capacity may be degraded. When said concentration is more than 14% by weight, precipitated materials or crystals may be easily generated, and gelation may be easily caused during neutralization of waste liquid, resulting in an obstacle to the waste disposal.

The aqueous alkaline developing solution has preferably a pH value of at least 10, more preferably of at least 11.5, most preferably of at least 12. There is no specific upper limit for the pH but the pH is usually not higher than 14, preferably not higher than 13.7.

In another embodiment of the present invention, the aqueous alkaline solution may further comprise a nonreducing sugar. The nonreducing sugar denotes sugars having no reductive property due to the absence of a free aldehyde group or a free ketone group. Said nonreducing sugar is classified into trehalose-type oligosaccharides wherein a reductive group and another reductive group make a linkage; glycosides wherein a reductive group in a sugar is linked to a non-sugar compound; and sugar alcohols which are produced by reducing a sugar with hydrogenation. Said trehalose-type oligosaccharides include sucrose and trehalose, and said glycosides include alkyl glycosides, phenol glycosides, mustard oil glycosides and the like. Said sugar alcohols include D,L-arabitol, ribitol, xylitol, D,L-sorbitol, D,L-mannitol, D,L-iditol, talitol, dulcitol, allodulcitol and the like. Further, maltitol obtained by hydrogenation of disaccharide, a reduced material obtained by hydrogenation of oligosaccharide (a reduced starch syrup) and the like are preferably used. Pentaerythritol can also be used in the developing solution.

In the above nonreducing sugar, preferred are sugar alcohols and sucrose, and particularly preferred are D-sorbitol, sucrose and a reduced starch syrup, since they have buffering action in appropriate pH range.

In a preferred embodiment, the aqueous alkaline solution further comprises a mono alkali metal or ammonium salt of an organic carboxylic acid, having 4 to 12 carbon atoms and substituted with 3 to 11 hydroxyl groups. Said organic carboxylic acid is more preferably a sugar acid, i.e. a sugar compound having a carboxylic acid group. The sugar acids have preferably at least 3 hydroxyl groups, more preferably at least 4 hydroxyl groups, most preferably at least 5 hydroxyl groups. The sugar acids have preferably at most 11 hydroxyl groups, more preferably at most 7 hydroxyl groups, most preferably at most 6 hydroxyl groups. Said sugar acids include gluconic acid, D-glucaric acid, pentaric acid, D-galacturonic acid, D-glucuronic acid, heptonic acid, D-gluco-heptonic acid, tartaric acid, erythronic acid, L-arabinoic acid, D-arabino-2-hexulosonic acid, glucopyranuronic acid and muramic acid. Preferred examples are gluconic acid, D-gluco-heptonic acid and L-arabinoic acid. Gluconic acid is highly preferred in the developing solution of the present invention.

The above nonreducing sugar may be used alone or in combination with other ingredients, and the concentration thereof in the developer ranges generally from 0.1 to 30% by weight, and preferably from 1 to 20% by weight.

The developer may optionally contain further components, such as buffer substances, complexing agents, antifoaming agents, organic solvents, corrosion inhibitors, dyes, surfactants and/or hydrotropic agents as known in the art.

In the aqueous alkaline developing solution, it is possible to simultaneously use organic solvents having solubility in water at 20 °C of not more than 15 % by weight according to need. Examples of such organic solvents are such carboxilic acid esters as ethyl acetate, propyl acetate, butyl acetate, amyl acetate, benzyl acetate, ethylene glycol monobutyl ether acetate, butyl lactate and butyl levulinate; such ketones as ethyl butyl ketone, methyl isobutyl ketone and cyclohexanone; such alcohols as ethylene glycol monobutyl ether, ethylene glycol benzyl ether, ethylene glycol monophenyl ether, benzyl alcohol, methylphenylcarbinol, n-amyl alcohol and methylamyl alcohol; such alkyl-substituted aromatic hydrocarbons as xylene; and such halogenated hydrocarbons as methylene dichloride and monochlorobenzene. These organic solvents may be used alone or in combination. Particularly preferred is benzyl alcohol in the invention. These organic solvents are added to the developer or replenisher therefor generally in an amount of not more than 10 % by weight and preferably not more than 5 % by weight.

Besides the components described above, the developing solution of the present invention preferably comprises a compound having alkyleneoxide groups, more preferably said compound is a non-ionic surfactant having alkyleneoxide groups. The alkyleneoxide groups may selected from ethyleneoxide groups, propyleneoxide groups or a combination of both. Such a non-ionic surfactant may be used as a dissolution preventing agent whereby the dissolution kinetic of non-exposed areas is reduced. Examples of nonionic surfactants include ethoxylated alcohols, polyethylene glycols and polyhydric alcohols. Ethoxylated alcohols are preferred, and in particular ethoxylated alcohols having a hydrophilic-lipophilic balance (HLB) higher than 5 are more preferred. Specific examples of nonionic surfactants are listed below: polyethylene glycol, polyoxyethylene glycol, lauryl ether, laurylalcohol polyglycol ethers, oleyl alcohol ethoxylated, lanolin alcohol ethoxylated, dodecanol ethoxylated, cetostearyl alcohol ethoxylated, tetramethyldecindiol ethoxylated, polyoxyethylene nonyl ether, polyoxyethylene cetyl ether, polyoxyethylene stearyl ether, polyoxyethylene oleyl ether, polyoxyethylene behenyl ether, polyoxyethylene polyoxypropylene block copolymers, polyoxyethylene polyoxypropylene cetyl ether, polyoxyethylene polyoxypropylene behenyl ether, polyoxyethylene nonylphenyl ether, polyoxyethylene octylphenyl ether, polyoxyethylene stearylamine, polyoxyethylene oleylamine, polyoxyethylene stearic acid amide, polyoxyethylene oleic acid amide, polyoxyethylene castor oil, polyoxyethylene abietyl ether, polyoxyethylene lanolin ether, polyoxyethylene monolaurate, polyoxyethylene monostearate, polyoxyethylene glyceryl monooleate, polyoxyethylene glyceryl monostearate, polyoxyethylene propylene glycol monostearate, polyoxyethylene sorbitan monolaurate, and sorbitan monolaurate. These non-ionic surfactants preferably have an average molecular weight ranging from 500 to 10,000, preferably from 1000 to 5000.

Block copolymers comprising chain segments of ethyleneoxide and propyleneoxide and having a branched structure are more preferred. Block copolymers comprising chain segments of ethyleneoxide and propyleneoxide, substituted on an amine, on ethylenediamine or on diethylenetriamine are still more preferred. Most preferred are these compounds wherein the amine group or the two amine groups of ethylenediamine or diethylenetriamine are substituted with 2, 3 or 4 chain segments of ethyleneoxide and propyleneoxide, e.g. Synperonic T304, commercially available from ICI, having a ratio of ethylenediamine, propyleneoxide and ethyleneoxide of 1/15/14 and having a mean molecular weight of 1600.

This compound having alkyleneoxide groups can be comprised individually or as a mixture of two or more compounds in an amount ranging from 0.05 to 5%, preferably from 0.1 to 1% by weight of the total developing solution.

The developers used in the present invention may simultaneously contain another surfactant for the purpose of improving developing properties thereof. By incorporating surfactants to the developer solution, the surface tension reduces drastically and the developer solution becomes effective - i.e. removal of the non-image areas without occurrence of stain/toning - at a lower pH compared to the same developer solution without a surfactant. The developer may comprise an ionic surfactant such as anionic or cationic surfactant, a non-ionic surfactant and/or amphoteric surfactants such as Librateric AA30 (trademark from Libra Chemicals Limited). Examples of such surfactants include salts of higher alcohol (C8 ~ C22) sulfuric acid esters such as sodium salt of lauryl alcohol sulfate, sodium salt of octyl alcohol sulfate, ammonium salt of lauryl alcohol sulfate, Teepol B-81 (trade mark, available from Shell Chemicals Co., Ltd.) and sodium alkyl sulfates; salts of aliphatic alcohol phosphoric acid esters such as sodium salt of cetyl alcohol phosphate; alkyl aryl sulfonic acid salts such as sodium salt of dodecylbenzene sulfonate, sodium salt of isopropylnaphthalene sulfonate,sodium salt of dinaphthalene disulfonate and sodium salt of metanitrobenzene sulfonate; sulfonic acid salts of alkylamides such as C₁₇H₃₃CON(CH₃)CH₂CH₂SO₃Na and sulfonic acid salts of dibasic aliphatic acid esters such as sodium dioctyl sulfosuccinate and sodium dihexyl sulfosuccinate. These surfactants may be used alone or in combination. Particularly preferred are phosphonic acid salts or combination of phosphonic and sulphonic acid salts.

The surfactants can be used in a concentration of generally not more than 5 % and preferably not more than 3 %. When anionic surfactants are used, the developing solution tends to build-up to much foam and therefor an antifoaming agent is added to suppress foaming. Example of a suitable antifoaming agent is Surfynol 104H, an acetylene glycol, commercially available from Keyser&Mackay. In a more preferred embodiment, the anionic surfactant has a sulphonic acid and/or a phosphonic acid group and is used in a concentration of not more than 1 %, more preferably not more than 0.5 %.

A cationic surfactant may also be used in the developer and may include amine salts, quaternary ammonium salts, phosphonium salts, sulfonium salts and the like. Examples of the amine salts are primary amine salts, secondary amine salts, tertiary amine salts, and imidazoline salts. Examples of the quaternary ammonium salts include tetraalkyl quaternary ammonium salts, trialkyl benzyl quaternary ammonium salts, alkyl pyridinium salts, alkyl quinolinium salts, imidazolinium salts and benzimidazolinium salts.

An amphoteric surfactant may also be used in the developer and may include betaine derivatives, such as, for example, alkylamidopropyl betaine, alkyldimethyl betaine, bishydroxyethyl betaine, alkylamido propyl betaine, lauryl betaine, and the like, glycine derivatives, such as, for example, cocoamphocarboxy glycinate, lauroamphocarboxy glycinate, caprylamphocarboxy glycinate, oleoamphocarboxy glycinate, oleoamphopolycarboxy glycinate, N-alkyl glycinate, and the like, imino derivatives, such as, for example, cocoiminodipropionate, octyliminodipropionate, and the like, imidazoline derivatives, such as, for example, coconut imidazoline, and the like, lecithin derivatives, and aminocarboxylic acids. These amphoteric surfactants preferably have an average molecular weight ranging from 500 to 10,000, preferably from 1,000 to 5,000. They can be comprised individually or as admixture of two or more compounds.

In order to enhance developing stability of the developers, the following compounds may simultaneously be used. Examples of such compounds are neutral salts such as NaCl, KCl and KBr as disclosed in JN-A- 58- 75 152; chelating agents such as EDTA and NTA as disclosed in JN-A- 58- 190 952 (U.S-A- 4 469 776), complexes such as [Co(NH₃)₆]Cl₃ as disclosed in JN-A- 59- 121 336 (US-A- 4 606 995); ionizable compounds of elements of the group IIa, IIIa or IIIb of the Periodic Table such as those disclosed in JN-A- 55- 25 100; anionic or amphoteric surfactants such as sodium alkyl naphthalene sulfonate and N-tetradecyl-N,N-dihydroxyethyl betaine as disclosed in JN-A- 50- 51 324; tetramethyldecyne diol as disclosed in US-A- 4 374 920; non-ionic surfactants as disclosed in JN-A- 60- 213 943; cationic polymers such as methyl chloride quaternary products of p-dimethylaminomethyl polystyrene as disclosed in JN-A- 55- 95 946; amphoteric polyelectrolytes such as copolymer of vinylbenzyl trimethylammonium chloride and sodium acrylate as disclosed in JN-A- 56- 142 528; reducing inorganic salts such as sodium sulfite as disclosed in JN-A- 57- 192 952 (US-A- 4 467 027) and alkaline-soluble mercapto compounds or thioether compounds such as thiosalicylic acid, cysteine and thioglycolic acid; inorganic lithium compounds such as lithium chloride as disclosed in JN-A- 58- 59 444; organic lithium compounds such as lithium benzoate as disclosed in JN-A- 50 34 442; organometallic surfactants containing Si, Ti or the like as disclosed in JN-A- 59- 75 255; organoboron compounds as disclosed in JN-A- 59- 84 241 (US-A- 4 500 625); quaternary ammonium salts such as tetraalkylammonium oxides as disclosed in EP-A- 101 010; and bactericides such as sodium dehydroacetate as disclosed in JN-A- 63- 226 657.

In accordance with the present invention, the alkaline developing solution comprises an alkali metal or ammonium salt of an aliphatic carboxylic acid, having 8 to 11 carbon atoms. In a preferred embodiment, said aliphatic carboxylic acid is octanoic acid, nonanoic acid, decanoic acid or undecanoic acid. In a more preferred embodiment, said aliphatic carboxylic acid is octanoic acid, nonanoic acid or decanoic acid, most preferably octanoic acid or nonanoic acid. The alkaline developing solution comprises preferably one of said compounds or a mixture of at least two of said compounds in a concentration ranging between 0.01 and 2.0 mol/l, more preferably between 0.03 and 1.0 mol/1, most preferably between 0.06 and 0.5 mol/1.

In another preferred embodiment of the present invention, said alkaline developing solution further comprises a compound comprising chain segments of ethyleneoxide and propyleneoxide groups, more preferably a non-ionic surfactant having alkyleneoxide groups, most preferably blockcopolymers comprising chain segments of ethyleneoxide and propyleneoxide, substituted on an amine, on an ethylenediamine or on a diethylenetriamine group.

In a still more preferred embodiment, the ratio of the concentration (in weight %) of said salt of aliphatic carboxylic acid to the concentration (in weight %) of said compound comprising chain segments of ethyleneoxide and propyleneoxide groups or said non-ionic surfactant or said blockcopolymer as mentioned above is between 1 and 20, more preferably between 2 and 15, most preferably between 3 and 10.

In a still further preferred embodiment of the present invention, the alkaline developing solution comprises, in addition to the above mentioned compounds, a sugar acid having 4 to 12 carbon atoms and substituted with 3 to 11 hydroxyl groups, more preferably at least one of gluconic acid, D-glucaric acid, pentaric acid, D-galacturonic acid, D-glucuronic acid, heptonic acid, D-gluco-heptonic acid, tartaric acid, erythronic acid, L-arabinoic acid, D-arabino-2-hexulosonic acid, glucopyranuronic acid and muramic acid, most preferably gluconic acid, D-gluco-heptonic acid and L-arabinoic acid.

In a still further preferred embodiment of the present invention, the alkaline developing solution comprises, in addition to the above mentioned compounds, an anionic surfactant comprising a sulphonic or phosphonic acid group.

In a still further preferred embodiment of the present invention, the alkaline agent in the alkaline developing solutions as defined above comprises an alkali metal silicate or metasilicate.

### Replenishing solution

During the development the non-image areas of the coating are removed with an aqueous alkaline developer solution optionally in combination combined with mechanical rubbing, e.g. by a rotating brush. During the development step, any water-soluble layer present is preferably also removed. The development is preferably carried out at temperatures of from 20 to 40 °C in automated processing units as customary in the art.

To perform development processing stably for a long time period, it is particularly important to control the strength of the silicate or metasilicate alkali and the concentration of other ingredients in the developer. Therefor, a replenishing solution, hereinafter also referred to as replenisher, is added to the developing solution, usually in small amounts such that a stable development processing can be performed over a long time period without exchanging the developer. Therefor, it is also important that the concentration of the aliphatic carboxylic acid, having 8 to 11 carbon atoms, of the present invention is present in the developing solution at a sufficiently high level in order to prevent the formation of floating products and this can be realised by adding a replenisher comprising the aliphatic carboxylic acid of the present invention.

For regeneration, the replenishing solution preferably comprises active ingredients of the developing solution such as alkaline agent, antisludge agent, buffer, dissolution preventing agent, antifoaming agent, complexing agent, anticorrosion agent, surfactant and the aliphatic carboxylic acid of the present invention. The replenishing solution is added continuously or in small amounts to the developing solution during or after the developing process in order to regulate the concentration of the active ingredients in the developing solution at a level sufficiently high or at a constant level such that the development of image-wise exposed precursors remains at a constant level. The required amounts of regenerated material must be tailored to the developing apparatuses used, daily plate throughputs, image areas, etc. and are in general from 1 to 150 ml per square meter of plate precursor. The addition of replenisher can be regulated, for example, by measuring the conductivity of the developer as described in EP-A 0,556,690 or, for example, replenisher is regularly added after a specified time period of processing.

In the method for development processing, any known means of supplementing a replenisher for developer may also be employed. Examples of such methods preferably used are a method for intermittently or continuously supplementing a replenisher as a function of the amount of plates processed and time as disclosed in JN-A- 55- 115 039 (GB-A- 2 046 931), a method comprising disposing a sensor for detecting the degree of light-sensitive layer dissolved out in the middle portion of a developing zone and supplementing the replenisher in proportion to the detected degree of the light-sensitive layer dissolved out as disclosed in JN-A- 58- 95 349 (US-A- 4 537 496); a method comprising determining the impedance value of a developer and processing the detected impedance value by a computer to perform supplementation of a replenisher as disclosed in GB-A- 2 208 249.

In a preferred embodiment of the present invention, the aliphatic carboxylic acid of the present invention is present in a replenishing solution at a concentration of at least 0.05 mol/l, preferably in a concentration ranging between 0.07 and 5.0 mol/l, more preferably between 0.1 and 3.0 mol/l, most preferably between 0.15 and 1.5 mol/l.

The replenishing solution has preferably a pH value of at least 10, more preferably of at least 11.5, most preferably of at least 12. There is no specific upper limit for the pH but the pH is usually not higher than 14.

In another embodiment of the present invention, more than one replenishing solutions can be used for adding to the developing solution during or after the development processing and these replenishers may contain different types of active ingredients and also the different types of active ingredients in different amounts for improving the development processing.

In a more preferred embodiment of the present invention, the fresh developing solution at starting the development processing for the first time comprises the aliphatic carboxylic acid of the present invention in a lower concentratration than in a used developing solution, and during or after processing a number of precursors, a replenishing solution, containing the aliphatic carboxylic acid of the present invention, is added to the developing solution whereby this concentration in the developing solution is increased to a higher level.

The heat-sensitive lithographic printing plate precursor of the present invention comprises a support having a hydrophilic surface or which is provided with a hydrophilic layer, and, on said support, a heat-sensitive coating.

### Support

The support of the lithographic printing plate precursor has a hydrophilic surface or is provided with a hydrophilic layer. The support may be a sheet-like material such as a plate or it may be a cylindrical element such as a sleeve which can be slid around a print cylinder of a printing press. A preferred support is a metal support such as aluminum or stainless steel. The metal can also be laminated to a plastic layer, e.g. polyester film. Alternative supports for the plate precursor can also be used, such as amorphous metallic alloys (metallic glasses). Such amorphous metallic alloys can be used as such or joined with other non-amorphous metals such as aluminum. Examples of amorphous metallic alloys are described in US5,288,344, US5,368,659, US5,618,359, US5,735,975, US5,250,124, US5,032,196, US6,325,868, and US6,818,078, the disclosures of which are incorporated by reference. The following references describe the science of amorphous metals in much more detail and are incorporated as references: Introduction to the Theory of Amorphous Metals, N.P. Kovalenko et al.(2001); Atomic Ordering in Liquid and Amorphous Metals, S.I. Popel, et al; Physics of Amorphous Metals, N.P. Kovalenko et al (2001).

A particularly preferred lithographic support is an electrochemically grained and anodized aluminum support. Graining and anodization of aluminum is well known in the art. The anodized aluminum support may be treated to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde It is further evident that one or more of these post treatments may be carried out alone or in combination. More detailed descriptions of these treatments are given in GB-A 1 084 070, DE-A 4 423 140, DE-A 4 417 907, EP-A 659 909, EP-A 537 633, DE-A 4 001 466, EP-A 292 801, EP-A 291 760 and US 4,458,005.

### Coating

The heat-sensitive coating, which is provided on the support, may be positive-working or negative-working. A positive-working heat-sensitive coating is preferred. The coating of a positive-working heat-sensitive coating does not dissolve in an alkaline developing solution in the unexposed areas and becomes soluble in the exposed areas within the time used for developing the plate.

The heat-sensitive coating comprises a first layer comprising a first polymer which is water-insoluble and alkali-soluble, and on said first layer, a second layer comprising a second polymer which is water-insoluble and alkali-soluble, and an infrared absorbing dye, present in at least one of said first and second layer, whereby the second layer exhibits an increased solubility in an aqueous alkaline developing solution upon heating or IR-radiation.

The second polymer is preferably an water-insoluble and alkali-soluble oleophilic resin whereof the solubility in an alkaline developing solution is reduced in the coating and whereof the solubility in an alkaline developing solution is increased upon heating or IR-radiation. The second layer preferably further comprises a dissolution inhibitor which may be the IR-dye or another compound whereby rate of dissolution of the second layer in an alkaline developing solution is reduced. Due to this solubility differential the rate of dissolution of the exposed areas is sufficiently higher than in the non-exposed areas.

In a preferred embodiment of the present invention, the second polymer is a phenolic resin such as novolac, resol or a polyvinylphenolic resin; novolac is more preferred. Typical examples of such polymers are described in DE-A-4007428, DE-A-4027301 and DE-A-4445820. Other preferred polymers are phenolic resins wherein the phenyl group or the hydroxy group of the phenolic monomeric unit are chemically modified with an organic substituent as described in EP 894 622, EP 901 902, EP 933 682, WO99/63407, EP 934 822, EP 1 072 432, US 5,641,608, EP 982 123, WO99/01795, WO04/035310, WO04/035686, WO04/035645, WO04/035687 or EP 1 506 858.

The novolac resin or resol resin may be prepared by polycondensation of at least one member selected from aromatic hydrocarbons such as phenol, o-cresol, p-cresol, m-cresol, 2,5-xylenol, 3,5-xylenol, resorcinol, pyrogallol, bisphenol, bisphenol A, trisphenol, o-ethylphenol, p-etylphenol, propylphenol, n-butylphenol, t-butylphenol, 1-naphtol and 2-naphtol, with at least one aldehyde or ketone selected from aldehydes such as formaldehyde, glyoxal, acetoaldehyde, propionaldehyde, benzaldehyde and furfural and ketones such as acetone, methyl ethyl ketone and methyl isobutyl ketone, in the presence of an acid catalyst. Instead of formaldehyde and acetaldehyde, paraformaldehyde and paraldehyde may, respectively, be used.

The weight average molecular weight, measured by gel permeation chromatography using universal calibration and polystyrene standards, of the novolac resin is preferably from 500 to 150,000 g/mol, more preferably from 1,500 to 50,000 g/mol.

The poly(vinylphenol) resin may also be a polymer of one or more hydroxy-phenyl containing monomers such as hydroxystyrenes or hydroxy-phenyl (meth)acrylates. Examples of such hydroxystyrenes are o-hydroxystyrene, m-hydroxystyrene, p-hydroxystyrene, 2-(o-hydroxyphenyl)propylene, 2-(m-hydroxyphenyl)propylene and 2-(p-hydroxyphenyl)propylene. Such a hydroxystyrene may have a substituent such as chlorine, bromine, iodine, fluorine or a C₁₋₄ alkyl group, on its aromatic ring. An example of such hydroxy-phenyl (meth)acrylate is 2-hydroxy-phenyl methacrylate.

The poly(vinylphenol) resin may usually be prepared by polymerizing one or more hydroxy-phenyl containing monomer in the presence of a radical initiator or a cationic polymerization initiator. The poly(vinylphenol) resin may also be prepared by copolymerizing one or more of these hydroxy-phenyl containing monomers with other monomeric compounds such as acrylate monomers, methacrylate monomers, acrylamide monomers, methacrylamide monomers, vinyl monomers, aromatic vinyl monomers or diene monomers.

The weight average molecular weight, measured by gel permeation chromatography using universal calibration and polystyrene standards, of the poly(vinylphenol) resin is preferably from 1.000 to 200,000 g/mol, more preferably from 1,500 to 50,000 g/mol.

Examples of phenolic resins are:
POL-01: ALNOVOL SPN452 is a solution of a novolac resin, 40 % by weight in Dowanol PM, obtained from CLARIANT GmbH.
Dowanol PM consists of 1-methoxy-2-propanol (>99.5 %) and 2-methoxy-1-propanol (<0.5 %) .
POL-02: ALNOVOL SPN400 is a solution of a novolac resin, 44 % by weight in Dowanol PMA, obtained from CLARIANT GmbH.
Dowanol PMA consists of 2-methoxy-1-methyl-ethylacetate.
POL-03: ALNOVOL SPN402 is a solution of a novolac resin, 44.3 % by weight, obtained from CLARIANT GmbH.
POL-04: ALNOVOL HPN100 a novolac resin obtained from CLARIANT GmbH.
POL-05: DURITE PD443 is a novolac resin obtained from BORDEN CHEM. INC.
POL-06: DURITE SD423A is a novolac resin obtained from BORDEN CHEM. INC.
POL-07: DURITE SD126A is a novolac resin obtained from BORDEN CHEM. INC.
POL-08: BAKELITE 6866LB02 is a novolac resin obtained from BAKELITE AG.
POL-09: BAKELITE 6866LB03 is a novolac resin obtained from BAKELITE AG.
POL-10: KR 400/8 is a novolac resin obtained from KOYO CHEMICALS INC.
POL-11: HRJ 1085 is a novolac resin obtained from SCHNECTADY INTERNATIONAL INC.
POL-12: HRJ 2606 is a phenol novolac resin obtained from SCHNECTADY INTERNATIONAL INC.
POL-13: LYNCUR CMM is a copolymer of 4-hydroxy-styrene and methyl methacrylate obtained from SIBER HEGNER.

In another preferred embodiment of the present invention, the first polymer is insoluble in water and soluble in an alkaline solution. The first polymer is preferably an organic polymer which has acidic groups with a pKa of less than 13 to ensure that the layer is soluble or at least swellable or dispersible in aqueous alkaline developers. Advantageously, the binder is a polymer or polycondensate, for example a polyester, a polyamide resin, an epoxy resin, an acetal resin, an acrylic resin, a methacrylic resin, a styrene based resin, a polyurethane resin or polyurea.

The first polymer has more preferably one or more functional groups selected from the list of
(i) a sulfonamide group such as -SO₂-NH-R^{g} wherein R^{g} represents a hydrogen or an optionally substituted hydrocarbon group such as an optionally substituted alkyl, aryl or heteroaryl group,
(ii) an active imide group such as -SO₂-NH-CO-R^{h}, -SO₂-NH-SO₂-R^{h} or-CO-NH-SO₂-R^{h} wherein R^{h} represents a hydrogen or an optionally substituted hydrocarbon group such as an optionally substituted alkyl, aryl or heteroaryl group,
(iii) a carboxyl group,
(iv) a sulfonic group, and
(v) a phosphoric group;
a sulfonamide group or an active imide group are more preferred; most preferred are polymers selected from a copolymer comprising a N-benzyl-maleimide monomeric unit or a monomeric unit comprising a sulfonamide group as described in EP-A 933 682, EP 0 894 622 (page 3 line 16 to page 6 line 30), EP-A 0 982 123 (page 3 line 56 to page 51 line 5), EP-A 1 072 432 (page 4 line 21 to page 10 line 29) and WO 99/63407 (page 4 line 13 to page 9 line 37). The first polymer has most preferably one or more sulfonamide groups as defined above and as defined in the non-published European Patent Application Nr. 06110501.1.

Other polymers having an acidic group are polycondensates and polymers having free phenolic hydroxyl groups, as obtained, for example, by reacting phenol, resorcinol, a cresol, a xylenol or a trimethylphenol with aldehydes, especially formaldehyde, or ketones. Condensates of sulfamoyl- or carbamoyl-substituted aromatics and aldehydes or ketones are also suitable. Polymers of bismethylol-substituted ureas, vinyl ethers, vinyl alcohols, vinyl acetals or vinylamides and polymers of phenylacrylates and copolymers of hydroxy-phenylmaleimides are likewise suitable. Furthermore, polymers having units of vinylaromatics, N-aryl(meth)acrylamides or aryl (meth)acrylates may be mentioned, it being possible for each of these units also to have one or more carboxyl groups, phenolic hydroxyl groups, sulfamoyl groups or carbamoyl groups. Specific examples include polymers having units of 2-hydroxyphenyl (meth)acrylate, of N-(4-hydroxyphenyl)(meth)acrylamide, of N-(4-sulfamoylphenyl)-(meth)acrylamide, of N-(4-hydroxy-3,5-dimethylbenzyl)-(meth)acrylamide, or 4-hydroxystyrene or of hydroxyphenylmaleimide. The polymers may additionally contain units of other monomers which have no acidic units. Such units include vinylaromatics, methyl (meth)acrylate, phenyl(meth)acrylate, benzyl (meth)acrylate, methacrylamide or acrylonitrile.

### Dissolution inhibitor

In a preferred embodiment of the present invention, the heat-sensitive coating contains one or more dissolution inhibitors, present in at least one of said first and second layer, more preferably present in the second layer. Dissolution inhibitors, hereinafter also referred to as inhibitor, are compounds which reduce the dissolution rate of the polymer, preferably the second polymer, in the aqueous alkaline developer at the non-exposed areas of the coating and wherein this reduction of the dissolution rate is destroyed by the heat generated during the exposure so that the coating readily dissolves in the developer at exposed areas. The dissolution inhibitor exhibits a substantial latitude in dissolution rate between the exposed and non-exposed areas. By preference, the dissolution inhibitor has a large dissolution rate latitude when the exposed coating areas have dissolved completely in the developer before the non-exposed areas are attacked by the developer to such an extent that the ink-accepting capability of the coating is affected. The dissolution inhibitor(s) are preferably added to the second layer which comprises the second polymer discussed above.

The dissolution rate of the non-exposed coating in the developer is preferably reduced by interaction between the polymer and the inhibitor, due to e.g. hydrogen bonding between these compounds. Suitable dissolution inhibitors are preferably organic compounds which comprise at least one aromatic group and a hydrogen bonding site, e.g. a carbonyl group, a sulfonyl group, or a nitrogen atom which may be quaternized and which may be part of a heterocyclic ring or which may be part of an amino substituent of said organic compound. Suitable dissolution inhibitors of this type have been disclosed in e.g. EP-A 825 927 and 823 327. The IR-dye can also have the function of dissolution inhibitor.

Water-repellent polymers represent an another type of suitable dissolution inhibitors. Such polymers seem to increase the developer resistance of the coating by repelling the aqueous developer from the coating. The water-repellent polymers can be added to the second layer and/or can be present in a separate layer provided on top of the second layer. In the latter embodiment, the water-repellent polymer forms a barrier layer which shields the coating from the developer and the solubility of the barrier layer in the developer or the penetrability of the barrier layer by the developer can be increased by exposure to heat or infrared light, as described in e.g. EP-A 864420, EP-A 950 517 and WO99/21725. Preferred examples of the water-repellent polymers are polymers comprising siloxane and/or perfluoroalkyl units. In one embodiment, the coating contains such a water-repellent polymer in an amount between 0.5 and 25 mg/m², preferably between 0.5 and 15 mg/m² and most preferably between 0.5 and 10 mg/m². When the water-repellent polymer is also ink-repelling, e.g. in the case of polysiloxanes, higher amounts than 25 mg/m² can result in poor ink-acceptance of the non-exposed areas. An amount lower than 0.5 mg/m² on the other hand may lead to an unsatisfactory development resistance. The polysiloxane may be a linear, cyclic or complex cross-linked polymer or copolymer. The term polysiloxane compound shall include any compound which contains more than one siloxane group -Si(R,R')-O-, wherein R and R' are optionally substituted alkyl or aryl groups. Preferred siloxanes are phenylalkylsiloxanes and dialkylsiloxanes. The number of siloxane groups in the (co)polymer is at least 2, preferably at least 10, more preferably at least 20. It may be less than 100, preferably less than 60. In another embodiment, the water-repellent polymer is a block-copolymer or a graft-copolymer of a poly(alkylene oxide) block and a block of a polymer comprising siloxane and/or perfluoroalkyl units. A suitable copolymer comprises about 15 to 25 siloxane units and 50 to 70 alkylene oxide groups. Preferred examples include copolymers comprising phenylmethylsiloxane and/or dimethylsiloxane as well as ethylene oxide and/or propylene oxide, such as Tego Glide 410, Tego Wet 265, Tego Protect 5001 or Silikophen P50/X, all commercially available from Tego Chemie, Essen, Germany. Such a copolymer acts as a surfactant which upon coating, due to its bifunctional structure, automatically positions itself at the interface between the coating and air and thereby forms a separate top layer even when the whole coating is applied from a single coating solution. Simultaneously, such surfactants act as a spreading agent which improves the coating quality. Alternatively, the water-repellent polymer can be applied in a solution, coated on top of the second layer. In that embodiment, it may be advantageous to use a solvent in the solution that is not capable of dissolving the ingredients present in the second layer so that a highly concentrated water-repellent phase is obtained at the top of the coating.

### Development accelerator

Preferably, also one or more development accelerators are included in the heat-sensitive coating, i.e. compounds which act as dissolution promoters because they are capable of increasing the dissolution rate of the non-exposed coating in the developer. The simultaneous application of dissolution inhibitors and accelerators allows a precise fine tuning of the dissolution behavior of the coating. Suitable dissolution accelerators are cyclic acid anhydrides, phenols or organic acids. Examples of the cyclic acid anhydride include phthalic anhydride, tetrahydrophthalic anhydride, hexahydrophthalic anhydride, tetrachlorophthalic anhydride, maleic anhydride, chloromaleic anhydride, alpha -phenylmaleic anhydride, succinic anhydride, and pyromellitic anhydride, as described in U.S. Patent No. 4,115,128. Examples of the phenols include bisphenol A, p-nitrophenol, p-ethoxyphenol, 2,4,4'-trihydroxybenzophenone, 2,3,4-trihydroxy-benzophenone, 4-hydroxybenzophenone, 4,4',4"-trihydroxy-triphenylmethane, and 4,4',3",4"-tetrahydroxy-3,5,3',5'-tetramethyltriphenyl-methane, and the like. Examples of the organic acids include sulfonic acids, sulfinic acids, alkylsulfuric acids, phosphonic acids, phosphates, and carboxylic acids, as described in, for example, JP-A Nos. 60-88,942 and 2-96,755. Specific examples of these organic acids include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid, and ascorbic acid. The amount of the cyclic acid anhydride, phenol, or organic acid contained in the coating is preferably in the range of 0.05 to 20% by weight, relative to the coating as a whole. In a preferred embodiment, the second layer comprises a dissolution accelerator, preferably a cyclic acid anhydride, phenol, or organic acid in an amount of 0.05 to 20% by weight, relative to the second layer.

### Exposure

The material can be image-wise exposed directly with heat, e.g. by means of a thermal head, or indirectly by infrared light, which is converted into heat by an infrared light absorbing compound, which may be a dye or pigment having an absorption maximum in the infrared wavelength range. The infrared light absorbing dye or pigment is present in the heat-sensitive coating and typically in a concentration ranging between 0.25 and 10.0 wt.%, more preferably between 0.5 and 7.5 wt.% relative to the coating as a whole. Preferred IR-absorbing compounds are dyes such as cyanine or merocyanine dyes or pigments such as carbon black. A suitable compound is the following infrared dye IR-1: 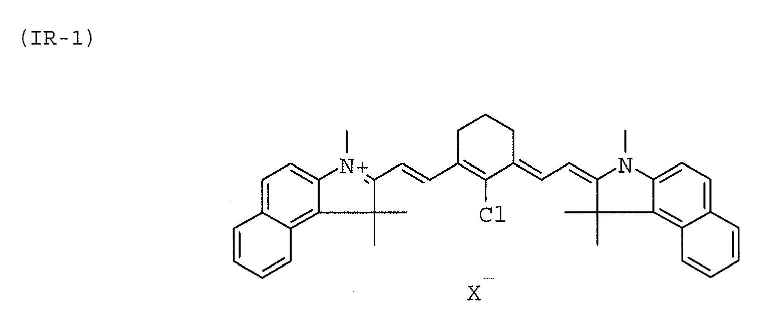 wherein X is a suitable counter ion such as tosylate.

The heat-sensitive coating may further contain an organic dye which absorbs visible light so that a perceptible image is obtained upon image-wise exposure and subsequent development. Such a dye is often called contrast dye or indicator dye. Preferably, the dye has a blue color and an absorption maximum in the wavelength range between 600nm and 750 nm. Although the dye absorbs visible light, it preferably does not sensitize the printing plate precursor, i.e. the coating does not become more soluble in the developer upon exposure to visible light. Suitable examples of such a contrast dye are the quaternized triarylmethane dyes.

According to a preferred embodiment, the contrast dye is present in the heat-sensitive coating.

According to a highly preferred embodiment, the infrared light absorbing compound is concentrated in the second layer of the heat-sensitive coating.

The printing plate precursor of the present invention can be exposed to infrared light with LEDs or a laser. Preferably, a laser emitting near infrared light having a wavelength in the range from about 750 to about 1500 nm is used, such as a semiconductor laser diode, a Nd:YAG or a Nd:YLF laser. The required laser power depends on the sensitivity of the image-recording layer, the pixel dwell time of the laser beam, which is determined by the spot diameter (typical value of modern plate-setters at 1/e² of maximum intensity : 10-25 µm), the scan speed and the resolution of the exposure apparatus (i.e. the number of addressable pixels per unit of linear distance, often expressed in dots per inch or dpi; typical value : 1000-4000 dpi).

Two types of laser-exposure apparatuses are commonly used: internal (ITD) and external drum (XTD) plate-setters. ITD plate-setters for thermal plates are typically characterized by a very high scan speed up to 500 m/sec and may require a laser power of several Watts. XTD plate-setters for thermal plates having a typical laser power from about 200 mW to about 1 W operate at a lower scan speed, e.g. from 0.1 to 10 m/sec.

The known plate-setters can be used as an off-press exposure apparatus, which offers the benefit of reduced press down-time. XTD plate-setter configurations can also be used for on-press exposure, offering the benefit of immediate registration in a multi-color press. More technical details of on-press exposure apparatuses are described in e.g. US 5,174,205 and US 5,163,368.

In the development step, the non-image areas of the coating are removed by immersion in an aqueous alkaline developer, which may be combined with mechanical rubbing, e.g. by a rotating brush. The developer preferably has a pH above 10, more preferably above 12.

The development step may be followed by a rinsing step and/or a gumming step. The gumming step involves post-treatment of the lithographic printing plate with a gum solution. A gum solution is typically an aqueous liquid which comprises one or more surface protective compounds that are capable of protecting the lithographic image of a printing plate against contamination or damaging. Suitable examples of such compounds are film-forming hydrophilic polymers or surfactants.

The plate precursor can, if required, be post-treated with a suitable correcting agent or preservative as known in the art. To increase the resistance of the finished printing plate and hence to extend the run length, the layer can be briefly heated to elevated temperatures ("baking"). The plate can be dried before baking or is dried during the baking process itself. During the baking step, the plate can be heated at a temperature which is higher than the glass transition temperature of the heat-sensitive coating, e.g. between 100°C and 230°C for a period of 40 seconds to 5 minutes. Baking can be done in conventional hot air ovens or by irradiation with lamps emitting in the infrared or ultraviolet spectrum. As a result of this baking step, the resistance of the printing plate to plate cleaners, correction agents and UV-curable printing inks increases. Such a thermal post-treatment is described, inter alia, in DE 1,447,963 and GB 1,154,749.

The printing plate thus obtained can be used for conventional, so-called wet offset printing, in which ink and an aqueous dampening liquid is supplied to the plate. Another suitable printing method uses so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

### Preparation of Binder-01.

In a 250 ml reactor, 162 mmol of Monomer-01, 21.3g (132 mmol) benzyl acrylamide, 0.43 g (6 mmol) acrylic acid and 103g gamma-butyrolactone were added and the mixture was heated to 140°C, while stirring at 200 rpm. A constant flow of nitrogen was put over the reactor. After dissolution of all the components, the reactor was cooled to 100°C. 0.35 ml Trigonox DC50, commercially available from AKZO NOBEL, was added followed by the addition of 1.39 ml Trigonox 141, commercially available from AKZO NOBEL, in 3.43 ml butyrolactone. The polymerization was started and the reactor was heated to 140°C over 2 hours while dosing 1.75 ml Trigonox DC50. The mixture was stirred at 400 rpm and the polymerization was allowed to continue for 2 hours at 140°C. The reaction mixture was cooled to 120°C and the stirrer speed was enhanced to 500 rpm. 85.7 ml 1-methoxy-2-propanol was added and the reaction mixture was allowed to cool down to room temperature.
Binder-01 was analyzed with ¹H-NMR-spectroscopy and size exclusion chromatography, using dimethyl acetamide/0.21 % LiCl as eluent on a 3x mixed-B column and relative to polystyrene standards.

| | Mₙ | M_{w} | PD |
|---|---|---|---|
| Binder-01 | 23500 | 67000 | 2.84 |

The reaction mixture was cooled to 40°C and the resulting 25 weight % polymer solution was collected in a drum.

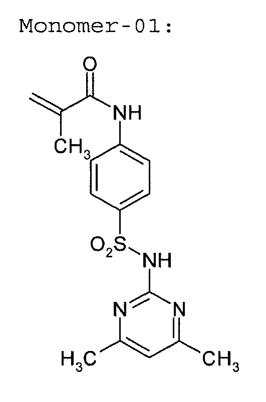

### Preparation of the lithographic support.

A 0.30 mm thick aluminum foil was degreased by immersing the foil in an aqueous solution containing 34 g/l of sodium hydroxide at 70°C for 6 seconds and rinsed with demineralized water for 3.6 seconds. The foil was then electrochemically grained during 8 seconds using an alternating current in an aqueous solution containing 15 g/l HCl, 15 g/l SO₄²⁻ ions and 5 g/l Al³⁺ at a temperature of 37°C and a current density of 100 A/dm². The aluminum foil was then desmutted by etching with an aqueous solution containing 145 g/l of sulfuric acid at 80°C for 5 seconds and rinsed with demineralized water for 4 seconds. The foil was subsequently subjected to anodic oxidation during 10 seconds in an aqueous solution containing 145 g/l of sulfuric acid at a temperature of 57°C and a current density of 25 A/dm², then washed with demineralized water for 7 seconds and post-treated for 4 seconds with a solution containing 2.2 g/l of polyvinylphosphonic acid at 70°C, rinsed with demineralized water for 3.5 seconds and dried at 120°C for 7 seconds.

The support thus obtained was characterized by a surface roughness Ra of 0.35-0.40 µm (measured with interferometer NT1100) and an anodic weight of 3.0 g/m².

### Preparation of the printing plate precursor PPP-01

The PPP-01 was produced by first applying a first coating layer defined in Table 1 onto the above described lithographic support. The total dry coating weight amounts to 0.71 g/m².

**Table 1: Composition of the first coating layer**

| INGREDIENTS | Amount of product (g/m²) |
|---|---|
| Binder-01 (1) | 0.6984 |
| Crystal Violet (2) | 0.0106 |
| Tegoglide 410 (3) | 0.0009 |

| | |
|---|---|
| (1)Binder-01, preparation see above, (2)Crystal Violet, commercially available from CIBA-GEIGY, (3)TEGOGLIDE 410 is a copolymer of polysiloxane and poly(alkylene oxide), commercially available from TEGO CHEMIE SERVICE GmbH. | |

On the first coated layer, a second layer as defined in Table 2 was coated at a dry coating weight of 0.52 g/m².

**Table 2: Composition of the solution of the second coating layer**

| INGREDIENTS | Amount of product (g/m²) |
|---|---|
| Alnovol SPN402 (1) | 0.4489 |
| TMCA (2) | 0.0266 |
| SOO94 (3) | 0.030 |
| Crystal Violet (4) | 0.0066 |
| Fluorad FC4432 (5) | 0.0067 |
| Tegoglide 410 (6) | 0.0014 |

| | |
|---|---|
| (1)Alnovol SPN402 is a novolac solution, 44.3 % by weight in Dowanol PM, commercially available from CLARIANT, (2)TMCA is 3,4,5-trimethoxy cinnamic acid, (3)SO094 is an IR absorbing cyanine dye, commercially available from FEW CHEMICALS; the chemical structure of SOO94 is equal to IR-1 (4)Crystal Violet: see Table 1, (5) FLUORAD FC4432 is a solution of a fluor-copolymer 1 % by weight in Dowanol PM, commercially available from 3M, (6)Tegoglide 410: see Table 1. | |

Imaging and processing of the printing plate precursor PPP-01.

A number of printing plate precursors PPP-01, having a total area of 5 m², were fully exposed with a Creo Trendsetter 2344T (40W, V1.7 head), a plate-setter, trademark from Creo, Burnaby, Canada, operating at 170 rpm and 2400 dpi and using an energy density of 130 mJ/cm².

After exposure the 5 m² plates were processed in a small table-top processor containing 0.5 1 of a developer solution as defined in Table 4 and Table 5, at a temperature of 35°C and a processing speed of 0.55 cm/s.

**Table 4: Composition of the developing solutions DEV-01 to DEV-04**

| INGREDIENTS | DEV-01 (g/l) | DEV-02 (g/l) | DEV-03 (g/l) | DEV-04 (g/l) |
|---|---|---|---|---|
| Na-metasilicate (1) | 100 | 100 | 100 | 100 |
| Crafol AP261 (2) | 3.24 | 1.62 | 3.24 | 3.24 |
| Surfynol 104H (3) | 0.67 | 0.67 | 0.67 | 0.67 |
| Synperonic T304 (4) | 4.32 | 4.32 | 4.32 | 4.32 |
| Sodium Gluconate (5) | 20 | 20 | 20 | 20 |
| Dowfax 2A1 (6) | - | 1.62 | | |
| Sodium Benzoate | | | 13.0 | |
| Salicylic acid | | | | 13.0 |

| | | | | |
|---|---|---|---|---|
| (1)Na-metasilicate is sodium metasilicate pentahydrate, commercially available from SILMACO NV (2)Crafol AP261 is alkylether sodium salt, commercially available from COGNIS (3)Surfynol 104H is a surfactant, commercially available from KEYSER&MACKAY (4)Synperonic T304 is a block-co-polymer of polyethylene oxide (=PEO) and polypropylene oxide (=PPO) attached to ethylenediamine (=EDA) in a ratio EDA/PEO/PPO of 1/15/14 and having a mean molecular weight of 1600, commercially available from UNIQEMA (5)Sodium Gluconate is Gluconic acid mono sodium salt (6)Dowfax 2A1 is an anionic surfactant, commercially available from Dow Chemical. | | | | |

**Table 5: Composition of the developing solutions DEV-05 to DEV-10**

| INGREDIENTS | DEV-05 (g/l) | DEV-06 (g/l) | DEV-07 (g/l) | DEV-08 (g/l) | DEV-9 (g/l) | DEV-10 (g/l) |
|---|---|---|---|---|---|---|
| Na-metasilicate (1) | 100 | 100 | 100 | 100 | 100 | 100 |
| Crafol AP261 (2) | 3.24 | 3.24 | 3.24 | 3.24 | 3.24 | 3.24 |
| Surfynol 104H (3) | 0.67 | 0.67 | 0.67 | 0.67 | 0.67 | 0.67 |
| Synperonic T304 (4) | 4.32 | 4.32 | 4.32 | 4.32 | 4.32 | 4.32 |
| Sodium Gluconate(5) | 20 | 20 | 20 | 20 | 20 | 20 |
| Hexanoic acid | 10.5 | | | | | |
| Heptanoic acid | | 11.8 | | | | |
| Octanoic acid | | | 13.1 | | | |
| Nonanoic acid | | | | 14.3 | | |
| Decanoic acid | | | | | 15.8 | |
| Dodecanoic acid | | | | | | 18.2 |

| | | | | | | |
|---|---|---|---|---|---|---|
| (1) to (5): see Table 4 | | | | | | |

After processing, the developing solution was heated to 30°C during 4 hours in the small table-top processor while continuously rotating the pair of exit rollers in the developer solution.

The level of formation of floating products deposited on the rollers was qualitatively evaluated as indicated in Table 6. The rating 1 stands for "no deposits", rating 2 for "limited film formation (small area films)", rating 3 for "outspoken film formation (large area films)", and rating 4 for "very outspoken film formation across the whole roll (very large area films)". The higher this rating number, the higher the amount of floating products deposited on the rollers under these simulation conditions. These ratings are a measure for the tendency to formation of floating products in the developer. Only rating 1 is acceptable in order to inhibit or reduce the formation of floating products and to extend the lifetime of the developing solution for processing printing plates without impairing the image.

Table 6 summarizes the amount of floating products deposited on the rollers for each type of developing solution DEV-01 to DEV-10.

**Table 6: Results**

| EXAMPLE | Precursor | Developer | Level of formation of floating products (Rating 1 to 4) |
|---|---|---|---|
| Comparative Example 1 | PPP-01 | DEV-01 | 4 |
| Comparative Example 2 | PPP-01 | DEV-02 | 3 |
| Comparative Example 3 | PPP-01 | DEV-03 | 2 |
| Comparative Example 4 | PPP-01 | DEV-04 | 2 |
| Comparative Example 5 | PPP-01 | DEV-05 | 2 |
| Comparative Example 6 | PPP-01 | DEV-06 | 2 |
| Invention Example 1 | PPP-01 | DEV-07 | 1 |
| Invention Example 2 | PPP-01 | DEV-08 | 1 |
| Invention Example 3 | PPP-01 | DEV-09 | 1 |
| Comparative Example 7 | PPP-01 | DEV-10 | (a) |

| | | | |
|---|---|---|---|
| (a) aliphatic carboxylic acid is not dissolved in the developing solution | | | |

The results in Tables 4 and 5 demonstrate that for the Invention Examples 1 to 3, comprising an aliphatic carboxylic acid of the present invention, floating products deposited on the rollers of the developing machine are not formed. Comparative Example 5 to 7 demonstrate that for hexanoic acid and heptanoic acid the aliphatic chain length is too short in order to prevent the formation of floating products in the developing solution completely and that for dodecanoic acid the number of carbon atoms too high to be sufficiently soluble in the developing solution. Comparative Examples 1 to 4 demonstrate that without an aliphatic carboxylic acid or with aromatic carboxylic acids floating products deposited on the rollers of the developing machine are formed.

## Claims

1. A method for making a lithographic printing plate comprising the steps of:
(1) providing a heat-sensitive lithographic printing plate precursor comprising on a support having a hydrophilic surface or which is provided with a hydrophilic layer, a heat-sensitive coating, said coating comprising a first layer comprising a first polymer which is water-insoluble and alkali-soluble, and on said first layer, a second layer comprising a second polymer which is water-insoluble and alkali-soluble, and an infrared absorbing dye, present in at least one of said first and second layer,
(2) image-wise exposing said precursor with IR-radiation or heat whereby said second layer exhibits an increased solubility in an aqueous alkaline developing solution, and
(3) developing said image-wise exposed precursor with an aqueous alkaline developing solution, said solution comprising an alkali metal or ammonium salt of an aliphatic carboxylic acid, having 8 to 11 carbon atoms.

2. A method according to claim 1, wherein said aliphatic carboxylic acid is octanoic acid, nonanoic acid, decanoic acid or undecanoic acid.

3. A method according to claim 1 or 2, wherein said salt of said aliphatic acid is present in said alkaline developing solution in a concentration ranging between 0.01 and 2.0 mol/1, more preferably between 0.03 and 1.0 mol/1, most preferably between 0.06 and 0.5 mol/1.

4. A method according to any of the preceding claims, wherein said alkaline developing solution further comprises a compound comprising chain segments of ethyleneoxide and propyleneoxide groups.

5. A method according to claim 4, wherein the ratio of the concentration (in weight %) of said salt of said aliphatic carboxylic acid to the concentration (in weight %) of said compound comprising chain segments of ethyleneoxide and propyleneoxide groups is between 1 and 20.

6. A method according to claim 1, wherein said developing solution further comprises a mono alkali metal or ammonium salt of an organic carboxylic acid, having 4 to 12 carbon atoms and substituted with 3 to 11 hydroxyl groups.

7. A method according to claim 3, wherein said organic carboxylic acid is a sugar comprising a carboxylic acid group.

8. A method according to claim 3 or 4, wherein said organic carboxylic acid is gluconic acid.

9. A method according to claim 1, wherein said first polymer comprises sulphonamide groups in the side chain of the polymer backbone.

10. A method according to claim 1, wherein said second polymer is a phenolic resin.

11. A method according to claim 1, wherein said precursor further comprises, on top of said second layer, a top layer comprising a polymer or surfactant comprising siloxane or perfluoroalkyl units.
